Europäisches Patentamt

European Patent Office

Office européen des brevets

(19)

(11) Publication number: **0 107 983**
**A1**

(12)

# EUROPEAN PATENT APPLICATION

(21) Application number: **83306611.1**

(22) Date of filing: **31.10.83**

(51) Int. Cl.³: **B 44 C 1/22**
**B 44 C 1/04, B 05 D 1/32**

(30) Priority: **29.10.82 JP 190161/82**

(43) Date of publication of application:
**09.05.84 Bulletin 84/19**

(84) Designated Contracting States:
**DE FR GB**

(71) Applicant: **Marui Industry Co. Ltd.**
**1-10 Sotokanda 5-chome Chiyoda-ku**
**Tokyo(JP)**

(72) Inventor: **Nakagawa, Shigeru**
**582 Takakura**
**Fujisawa-shi Kanagawa-ken(JP)**

(72) Inventor: **Uchikawa, Kiyotaka**
**319 Shinomiya**
**Hiratsuka-shi Kanagawa-ken(JP)**

(74) Representative: **Spall, Christopher John et al,**
**BARKER, BRETTELL & DUNCAN 138 Hagley Road**
**Edgbaston Birmingham B16 9PW(GB)**

(54) Method for forming patterns in a metal layer.

(57) The method includes the steps of: printing a pattern (I) on a member using an ink which can be easily detached from the member; forming the metal layer (14) on the member with the printed patterns by vacuum evaporation, by spattering or the like; and then, removing the ink cover patterns and the metal provided on the ink to thereby form the patterns.

*FIG. 1*

EP 0 107 983 A1

# METHOD FOR FORMING PATTERNS IN A METAL LAYER

This invention relates to a method for forming a metal layer with desired patterns including characters, marks and the like which are not coated with metal on the surface of a member such as a synthetic resin plate or a ceramic plate.

In the prior art, it has been known that such patterns are formed by a partial chemical-electro plating process or by an etching process.

In the partial chemical-electro plating process, desired patterns are printed on the surface of a member such as a synthetic resin plate or a ceramic plate by a material which has an inaffinity for metal, then the member is subjected to a chemical metal plating process so that the member is coated with a very thin metal layer in which the desired patterns on the surface of the member are not coated with metal, and, thereafter, the member is subjected to an electro plating process to form a final metal layer containing the desired patterns which are not coated with metal. However, this method has the following defect: electric current concentrates in the electro plating process at the border-line portions of the metal layer preformed by the chemical plating process, so that extra metals are extracted on that portions in the form of needles or grains. To avoid such a defect, it is required that the thickness of the metal layer be made relatively thin. However, when this is done, the length of time that such a thin layer will remain on the member surface will be of short duration. In addition, other characteristics associated with the layer will be of low quality. Further, materials to be plated and the processes for such plating are very limited.

In the other method stated above, the etching method, an acid or a salt is used. This method comprises the steps of coating a surface of a metal member with an etchant resist, hardening predetermined areas in the resist coating in accordance with desired patterns to be formed, washing out the resist from areas other than the hardened areas, and then etching the member to remove the metal from the areas from which the resist has been washed out, and thereby forming opening corresponding to the desired patterns in the plate. Since in this method an acid or an alkali is used, it is required to process the waste fluid. Further, since the resist remains on the metal member, the resist should be removed when the member is used as a decorative material.

Accordingly, an object of this invention is to provide a method for forming patterns in a metal layer provided on a member in such a way that the above stated defects in the prior art are eliminated.

A method in accordance with the invention comprises the steps of:

printing characters, marks and/or other patterns on a member by screen printing, relief printing or the like;

coating the member with a metal by vacuum evaporation, spattering or the like; and

then removing the ink provided on the member in the first step together with the metal thereon.

The advantageous effects obtained in this method are as follows:

1.    The edges of the patterns are clearly defined.

2.    Any material can be used as a member on which the metal layer is provided.

3.    The metal layer provided on the member may be made from many kinds of metals which are suitable as materials to be used in vacuum evaporation, spattering or the like.

4.    Since an acid or an alkali is not used, there is no necessity to process the waste fluid and thus this method is desirable for the purpose of avoiding environmental pollution.

The invention, its object and its advantages, will become more apparent from the detailed description of the preferred embodiment presented below.

In the detailed description of the preferred embodiment of the invention, reference is made to the accompanying drawings, in which:

Fig. 1 is a front view of a displaying plate made in accordance with the invention; and

Fig. 2 is a section-view taken along the line of II-II in Fig. 1.

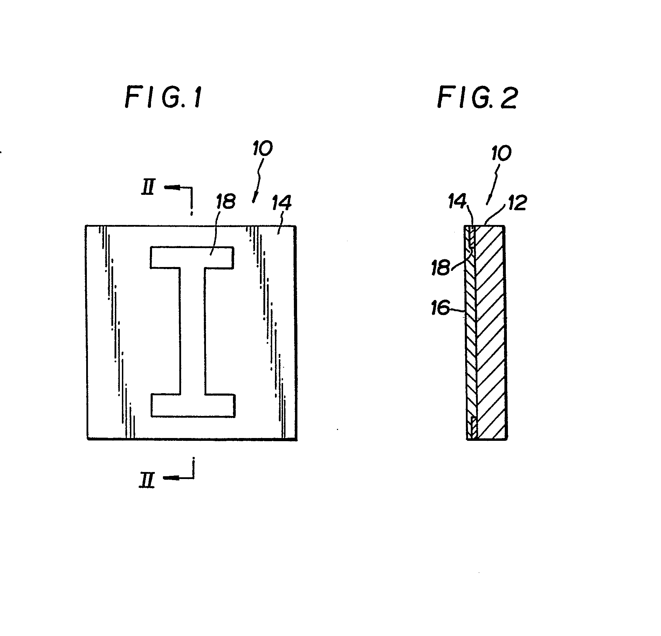

Referring to Figs. 1 and 2, a displaying plate 10 made in accordance with the invention comprises a plate 12 made of ceramics, synthetic resins or the like material, a metal layer 14 provided on the surface of the plate and a transparent protective layer 16 coating the metal layer, with a pattern "I" being formed in the metal layer 14 by removing the metal of the area in the metal layer corresponding to the pattern. A method for producing the displaying plate is as follows:

First, a plate 12 of synthetic resin (such as acrylic resin) is printed using a printing ink in the pattern "I". Then, the metal layer 14 is formed by vacuum evaporation or spattering with, for example, a nickel-chrome alloy. Thereafter, the plate is put in the hydrocarbonic solvent to dissolve the ink and to thereby remove the metal deposited thereon, so that the pattern "I" is formed. In this case, it is advisable to apply supersonic vibrations to the plate while the plate is put into the solvent in order to phisically promote the removal of the ink and the metal. Incidentally, prior to the printing of the pattern, an organic based paint may be provided on the plate 12 so as to make it easy to form the metal layer thereon by vacuum evaporation or by spattering.

In the above stated process, a halogenated hydrocarbonic solvent may be used as a solvent for dissolving the printing ink. Further, ceramics, various kinds of synthetic resins (polycarbonate, ABS resin, polyacetate, PPO, PBT, nylon etc.) may be used as the material of plate 12. As materials of the metal layer, nickel, chrome, copper alloy or metals other than the nickel-chrome alloy used in the above stated embodiment may be selectively used. The protective layer 16 is formed by coating a transparent material over the metal layer with the mark. The transparent material may contain flatting agent therein to provide a flatted appearance of the indicating portion. The protective layer is not essential and may be eliminated.

Though, the invention is explained above in conjunction with the process for making a displaying plate, the invention can be applied to production of printed circuit boards or the like.

Claims:

1.     A method for forming a metal layer with patterns such as characters and marks which are not coated with metal on a member such as a synthetic resin plate or a ceramic plate, the method including the steps of:

printing the patterns on said member using an ink which can be easily detached from said member;

forming the metal layer on said member with said printed patterns by vacuum evaporation, by spattering or the like; and

then, removing said ink cover patterns and the metal provided on the ink to thereby form said patterns.

2.     The method as set forth in Claim 1 including a further step of coating said member with an organic based paint prior to printing the patterns.

3.     The method as set forth in Claim 1 or 2 in which after the step of forming the metal layer, said member is put into a solvent for dissolving said ink and supersonic vibrations are applied to the member to thereby remove the ink of patterns and the metal provided thereon.

# FIG.1

# FIG.2

# European Patent Office

## EUROPEAN SEARCH REPORT

Application number

EP 83 30 6611

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| X | US-A-4 242 378 (Y. ARAI) <br> * Column 2, lines 15-21,49-57 * | 1,2,3 | B 44 C 1/22 <br> B 44 C 1/04 <br> B 05 D 1/32 |
| A | GB-A-1 020 664 (S. FOWLER) <br> * Claim 17 * | 1,3 | |
| A | GB-A- 957 292 (IWATANI SANGYO K.K.) <br> * Page 2, lines 10-14 * | 1,3 | |
| A | CH-A- 340 163 (MONNIER) <br> * Whole document * | 1 | |

TECHNICAL FIELDS SEARCHED (Int. Cl. 3)

B 44 C
B 05 D

The present search report has been drawn up for all claims

| Place of search | Date of completion of the search | Examiner |
|---|---|---|
| THE HAGUE | 02-02-1984 | FRIDEN N. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82